# EUROPEAN PATENT SPECIFICATION

(11) **EP 3 337 913 B1**
(45) Date of publication and mention of the grant of the patent: **06.10.2021**
(21) Application number: 16751615.2
(22) Date of filing: 17.08.2016
(51) Int. Cl.: C23C 14/02, C23C 14/16, C23C 14/56, C23C 14/58, C11D 11/00

(54) **METHOD AND APPARATUS FOR THE CLEANING AND COATING OF METAL STRIP**
VERFAHREN UND VORRICHTUNG ZUR REINIGUNG UND BESCHICHTUNG EINES METALLBANDES
PROCÉDÉ ET APPAREIL POUR LE NETTOYAGE ET LE REVÊTEMENT DE BANDE MÉTALLIQUE

(30) Priority: 18.08.2015 EP 15020138
(43) Date of publication of application: 27.06.2018
(73) Proprietor: Tata Steel Nederland Technology B.V., 1951 JZ Velsen-Noord (NL)
(72) Inventor: ZOESTBERGEN, Edzo, 1970 CA IJmuiden (NL); MAALMAN, Theodorus Franciscus Jozef, 1970 CA IJmuiden (NL); WESSELINK, Johan Jacob Hendrik, 1970 CA Ijmuiden (NL)
(74) Representative: Group Intellectual Property Services
(86) International application number: PCT/EP2016/069505
(87) International publication number: WO 2017/029320

(56) References cited:
- WO-A1-2005/045093
- JP-A- H06 173 002
- US-A1- 2007 031 600
- US-A1- 2010 272 918

## Description

### Field of the invention

The invention relates to an apparatus for the cleaning and the coating of metal strip, wherein the cleaning is carried out by means of a plasma treatment process and the coating is applied by means of a vacuum vapour deposition process. Vacuum vapour deposition includes Physical Vapour Deposition (PVD) and Chemical vapour Deposition (CVD) and although the term PVD will be used throughout the description it is meant to refer both to PVD and CVD as applicable.

### Background of the invention

Important issues with applying a coating on a metal substrate, such as a steel strip, by means of PVD on an industrial scale are to maintain the required vacuum for the PVD process and to keep the deposition chamber in which the coating is applied to the strip free from contaminations as much as possible. Contamination of the deposition chamber may occur by means of coating vapour that instead of on the metal strip deposits on the walls of the chamber. Another form of contamination is residues resulting from cleaning the metal strip.

A continuous PVD coating installation is provided with entry and exit sections provided with air locks to feed the metal strip in and out of the installation. To operate a PVD coating installation cost effectively the process should be operated in a continuous process as much as possible. A prerequisite for this is to keep the level of contamination to an absolute minimum and therewith the frequency of maintenance stops.

Known PVD coating technologies like electron beam or magnetron sputtering have a vapour yield between 60 and 95%, wherein the vapour yield is the ratio of deposited vapour on the metal strip divided by the total produced vapour. This means that with these technologies between 5-40% of the vapour will contaminate the deposition chamber requiring regular cleaning of the deposition chamber therewith interrupting the coating process frequently and for considerable time.

EP0909342 discloses a method to produce zinc coated steel strip with a vapour yield of almost 100%. This is achieved by combining a vapour distribution section, which alone is already capable of realising a vapour yield of ≥ 99%, with a heated channel and using an increased pressure within the deposition chamber in comparison with the pressure used in conventional PVD coating processes, which is of the order 10⁻⁴ mbar or lower. The temperature of the walls of the heated channel are related to the vapour pressure of the material and the pressure in the channel. The use of a heated channel results in that coating material will not deposit on the wall but is redirect onto the strip and given a second or third or fourth change to deposit on the metal strip.

Vapour distribution sections are disclosed in EP1902152 and in "Jet vapor deposition a novel vacuum coating technique with superior properties", B. Schmitz, Revue de Metallurgie, Vol. 97, Nr. 7/8, p. 971-978, 2000.

The use of a heated channel also allows to operate the PVD coating process at an increased pressure, which is about three orders of magnitude higher than the conventional pressure. The advantage of such a higher pressure is that the number of conventional air lock sections at the entry and exit for the metal strip can be reduced by a number of sections. An air lock with multiple sections is disclosed in EP1627096.

A metal strip also needs to be cleaned and activated prior to the coating deposition process. This cleaning is most frequently done with a plasma sputtering technology, like for example with magnetron sputtering. Another cleaning method that could be applied involves the use of an electric arc discharge device as disclosed in WO2008074312. In WO2012091409 the cleaning and coating of advanced high strength steels is disclosed, wherein oxides present on the surface of the steel are removed by means of plasma, plasma arc and or laser cleaning before applying a coating on such a steel.

US 2010/0272918 A1 discloses a method and apparatus for cleaning and coating a metal strip. The method comprises the steps of cleaning the metal strip by magnetron or plasma etching in a cleaning chamber, followed by evaporating a metal in the connected coating chamber and applying the vapour to the substrate via a confinement chamber.

However, all these cleaning methods suffer from the major problem, that the residues coming from the sputtered layer will inevitably contaminate the deposition chamber. The oxide layer on the steel strip can have a thickness from 1 to 50 nanometres. In some cases and especially for Advanced and Ultra High Strength Steels the oxide layer can be from several tens to several hundreds of nanometres.

Such amounts of residues result in a contamination of the deposition chamber that completely eliminates all the advantages obtained by using a combination of a vapour distribution box and a heated channel.

### Objectives of the invention

It is an objective of the present invention to provide a method and an apparatus for the cleaning and the coating of metal strip, wherein contamination is prevented as much as possible.

It is another objective of the present invention to provide a method and an apparatus for the cleaning and the coating of metal strip, wherein it is prevented as much as possible that residues of the cleaning process enter the deposition chamber and as such influences the coating deposition or coating properties.

It is another objective of the present invention to provide a method and an apparatus for the cleaning and the coating of metal strip, wherein residues of the cleaning process are removed from the apparatus.

It is another objective of the present invention to provide a method and an apparatus for the cleaning and the coating of metal strip, wherein the pressure for the cleaning of the metal strip is higher than in the conventional PVD process.

It is another objective of the present invention to provide a method and an apparatus for the cleaning and the coating of metal strip, wherein the pressures of the cleaning process and the coating process are of the same order or do not differ more than one order of magnitude.

It is another objective of the present invention to provide a method and an apparatus for the cleaning and the coating of metal strip that allows operating the PVD coating process of a metal strip at reduced costs in comparison with the conventional PVD coating process.

It is still another objective of the present invention to provide a Zn-based coated steel strip product with superior adhesive bonding properties in comparison with a Zn-based coated steel strip product, produced at conventional deposition chamber pressure.

It is yet another objective of the present invention to provide a Zn-Mg coated steel strip product with superior adhesive bonding properties in comparison with a Zn-Mg based coated steel strip product, produced at conventional deposition chamber pressure.

### Description of the invention

According to a first aspect of the invention one or more of the objectives of the invention are realized by providing a method for cleaning and coating a metal strip comprising the steps of:
- cleaning the metal strip prior to applying a coating,
- generating a coating vapour by heating a material in a vapour chamber,
- applying the coating vapour in a deposition chamber via a vapour distribution section connected to the vapour chamber on the metal strip, and
- wherein the coating is applied in a heated enclosure,
- wherein the metal strip is cleaned in a cleaning chamber connected to the deposition chamber and wherein the pressure in the cleaning chamber is kept in the range of 0.01 - 100 mbar and the pressure in the deposition chamber in the range of 0.01 -10 mbar,
- wherein a gas stream is maintained through the cleaning chamber to remove residues resulting from the cleaning of the metal strip before the metal strip enters the deposition chamber,
- wherein the gas stream is maintained by supplying gas into the cleaning chamber while removing the supplied gas with vacuum pump means and by using a gas bearing lock between the cleaning chamber and the deposition chamber.

Providing that the cleaning of the metal strip and the coating of the metal strip is carried out in separate chambers contributes to keeping the contamination of the coating chamber to a minimum.

A further advantage of the method is obtained by using low to medium vacuum for the cleaning chamber and coating chamber, which is easier to provide and easier to maintain than the high vacuum of the order 10⁻⁴ mbar, typically applied for metallic coating using PVD. Moreover, the pressure in the cleaning chamber and deposition chamber can be of the same order which has the advantage that there is no, or only limited need for air locks for the passage from the cleaning chamber to the deposition chamber. The gas stream is kept below a certain limit such that it does not negatively influence the plasma cleaning. While using a cleaning device that operates in medium to low vacuum it will be easy to maintain the vacuum and at the same time have a certain gas flow through the cleaning chamber to remove residue resulting from the cleaning operation. For this purpose the cleaning chamber is provided with a gas inlet connected to gas supply means, while vacuum pump means take care of the removal of the supplied gas. In this respect "gas" means for instance dry air, nitrogen or argon or any other suitable gas which does not affect the surface of the metal strip. The advantage of providing a gas bearing lock is that there is no direct contact between the gas bearing lock and the strip. Furthermore, the required pressure of the gas bearing lock and its working principle will generate a gas stream that will improve the removal of residue resulting from the cleaning operation. Gas bearing locks are known in the art, see for instance WO2007/016688. Such a gas bearing lock further provides that if necessary a difference in vacuum pressure between the cleaning chamber and deposition chamber can easily be maintained.

According to a further aspect of the method it is provided that the metal strip is cleaned by using a plasma cleaning technique. Such plasma cleaning could for instance be done by means of a magnetron sputtering device, an electric arc discharge device or an dielectric barrier discharge device. Preferably one of the latter two devices are used in the method since these can be used at higher pressures than magnetron sputtering. Cleaning by means of an electric arc discharge device is disclosed in WO2008074312. Although these devices could even be used at atmospheric pressures, it is preferred to use these in a vacuum to avoid the vapour productivity disadvantages typically associated with atmospheric pressure.

According to a further aspect of the invention an intermediate chamber is provided between the cleaning chamber and the deposition chamber with gas bearing locks connecting the intermediate chamber to the cleaning chamber and the deposition chamber. With the use of an intermediate chamber with gas bearing locks on both sides a separate chamber is obtained which is used to remove residues coming from the cleaning operation and which prevents that any of these residues enters the deposition chamber. Moreover the pressure in the intermediate chamber can be adjusted to any difference in pressure between cleaning chamber and coating chamber. The size of the intermediate chamber could be far less than the size of the cleaning chamber and/or the deposition chamber, therewith allowing to easily maintain a certain pressure in the intermediate chamber. Moreover, the removal of residues can easier be achieved with a relatively small intermediate chamber.

According to a further aspect of the invention the method comprises that the metal strip is mechanically cleaned before entering the deposition chamber. With mechanical cleaning is meant that the surface of the metal strip is treated with scraper means, brush means or any other like mechanical means. Mechanical cleaning is carried out after the plasma cleaning step and is aimed at removing residue that is still present on or attached to the surface of the metal strip.

According to a further aspect of the invention the method comprises that residues still remaining on the metal strip are removed by subjecting the metal strip to a stream of pressurised gas inside the intermediate chamber. Such a stream of pressurised gas in not only effective in removing residue still present on the metal strip but can also be used to effectively cool the metal strip. This is in particular necessary when thick layers of oxide have been removed from the strip as a consequence of which the strip temperature has increased considerably.

The mechanical cleaning is done either in the cleaning chamber or in the intermediate chamber. Preferably the metal strip is mechanically cleaned inside the intermediate chamber which allows for an easy removal of the residue making use of the vacuum pump system of the gas bearing lock.

The method further provides that the metal strip is activated before a coating is applied. Activation of the metal strip is in fact a low intensity cleaning of the metal strip. Such a treatment is necessary to provide a surface with sufficient bonding properties for some Zn-based coatings like Zn-Mg coatings. The activation of the surface of the metal strip can take place in the intermediate chamber or in the deposition chamber. The latter is allowed because the activation is a low intensity cleaning step with hardly any resulting residue. It is important that the activation is done close to the location where the coating is applied on the metal strip. Therefore it will be dependent on the dimensions of the intermediate chamber and the deposition chamber if the activation step is carried out in the intermediate chamber or in the deposition chamber.

The invention further provides an apparatus for cleaning and coating a metal strip provided with:
- a deposition chamber,
- air locks at the entry and exit sections for the metal strip to enter and exit the apparatus,
- a vapour chamber to heat a metal and generate a coating vapour,
- a vapour distribution section with one or more orifices to direct the coating vapour to the metal strip,
- a hood at least partially enclosing a space which connects to the distribution section with an open side directed at the metal strip which is to be coated,
- heating means to heat the hood, and
- connecting means to connect the vapour chamber to the distribution section in the deposition chamber,
- a cleaning chamber provided with a plasma cleaning device to clean the metal strip and wherein the cleaning chamber is connected to the deposition chamber wherein the coating vapour is applied to the metal strip,
- a gas inlet to supply gas into the cleaning chamber, and
- vacuum pump means to remove the supplied gas from the cleaning chamber.

According to a further aspect of the invention the cleaning chamber is provided with means to provide a gas stream through the cleaning chamber and maintaining a pressure in the range of 0.01 - 100 mbar, preferably in the range of 0.1 - 50 mbar. By cleaning within this pressure range a gas stream can be maintained through the cleaning chamber to remove residues resulting from the cleaning of the metal strip before the metal strip enters the deposition chamber. At the same time the desired pressure can be maintained, especially within the higher part of the pressure range, rather easily without the need of pumps specifically designed for high-vacuum purposes. With this embodiment the cleaning chamber could be connected directly to the deposition chamber. If both chambers are operated at about the same pressure the connection could be a simple slit shaped opening. With a difference in pressure an air lock or a gas bearing lock could be used to prevent any pressure equalisation between chambers.

A further embodiment according to the invention provides that the connection between cleaning chamber and deposition chamber includes an intermediate chamber provided with air locks on opposite sides. With such an intermediate chamber any pressure difference between cleaning chamber and deposition chamber can be maintained without difficulty. Moreover, with the use of such an intermediate chamber it can be prevented that almost any contamination from the cleaning chamber, such as residue resulting from the cleaning operation, reaches the deposition chamber.

A further elaboration of the invention provides that at least one of the air locks is a gas bearing lock with at least one gas permeable bearing surface with gas supply means and one or more grooves connected to gas pumping means. The grooves and pumping means provide that gas coming from the bearing parts is removed and that a certain pressure is maintained.

In the set-up with an intermediate chamber at least the gas bearing lock at the side of the cleaning chamber is provided with one or more grooves preceding a gas permeable surface. With the grooves preceding the bearing part at least part of the residue coming from the cleaning operation can be removed before it could enter into the intermediate chamber.

According to a further aspect it is provided that the grooves and gas permeable bearing surfaces are provided in opposite pairs of grooves and bearing surfaces. With the gas coming from the opposite bearing parts of such gas bearing lock the metal strip is kept at a distance from the surface of both bearing parts and the metal strip passes through the gas bearing lock without that either side of the strip comes into contact with the gas bearing lock.

Instead of a gas bearing with opposite pairs of grooves and gas permeable surfaces it is also possible to use a configuration with a roll at one side of the strip and a number of grooves or a number of grooves and gas permeable surfaces at the other side of the strip. Such a configuration could be appropriate between the intermediate chamber and the deposition chamber at which point any possible residue is already removed from the strip.

A brush may be provided at the location of the one or more pairs of opposite grooves in between successive pairs of opposite gas permeable surfaces in order to mechanically remove any residue still present on or adhering to the metal strip.

According to a further aspect of the invention a pressurised gas supply is provided and means inside the intermediate chamber to guide a stream of pressurised gas at the surface of the metal strip. Such a stream of pressurised gas in not only effective in removing residue still present on the metal strip but can also be used to effectively cool the metal strip. This is in particular necessary when thick layers of oxide have been removed from the strip as a consequence of which the strip temperature has increased considerably.

Next to the stream of pressurised gas supply at least one outlet channel is provided for the removal of supplied pressurised gas or supplied pressurised gas together with residue.

The gas bearing lock between the intermediate chamber and the deposition chamber is the transition from the pressure inside the intermediate chamber and the deposition chamber. At the same time if still any of the residue from the cleaning operation reaches this stage it will be removed before entering the deposition chamber. At this point also a standard air lock could be used, the more so if there is only a small pressure difference between the intermediate chamber and the deposition chamber.

### Example 1:

This example describes the tests conducted to investigate the influence of air bearings on an activated and cleaned strip. To this end the strip was firstly cleaned in a roll to roll batch chamber at an operating pressure of 5·10⁻⁴ mbar using a magnetron sputtering unit operating at a power density of 200 kJ/m2. The magnetron sputter unit was used to clean/activate and to heat the strip. From a cleaning and activation perspective a cleaning density of >40kJ/m2 is sufficient. After the cleaning, the steel strip is coiled and the pressure in the chamber is increased to a pressure in the range from 0.1 to 5 mbar with either, argon, nitrogen or dry air. This is done while the booster and the roots pump are still on to maximise the gas flow through the deposition chamber. Then the coil is unwound travelling for a certain period in this increased atmosphere which results in gas atoms bouncing onto the strip, the same will happen when an activated strip passes through a gas bearing lock. Finally, in the same atmosphere zinc and zinc-magnesium coatings of 3 micron are deposited onto the strip. The adhesion of these samples is tested using a crash adhesion test (BMW AA-M223). The results are compared to adhesion tests of samples produced after sputtering at 5·10⁻⁴ mbar and directly coating the cleaned/activated steel strip at this pressure. The results show that for magnesium containing coating the adhesion deteriorates and no acceptable adhesion can be achieved. For zinc containing coating the adhesion is okay for all the tests samples and the contact with the gas atoms do not change the adhesion behaviour of the zinc coating.

**Table 1**

| Pressure (mbar) | *5·10⁻⁴* | *5·10⁻⁴* | 1 | *1* | 1 | 5 |
|---|---|---|---|---|---|---|
| Time exposure to pressure (s) | *40* | *40* | 160 | *160* | | 320 |
| Coating weight (g/m2) | *21* | *17* | 20 | *16* | | 18 |
| Mg% | *0* | *2* | 0 | *2* | | 0 |
| BMW results | *0* | *0* | 0 | *1* | | 0 |

### Brief description of the drawings

The invention is further explained on hand of the figures in which:
- Fig.1: shows a diagram of deposition chamber contamination as function of vapour yield and coating thickness,
- Fig.2: shows a diagram of deposition chamber contamination as function of the oxide layer thickness,
- Fig.3a: shows schematically a lay-out of a cleaning chamber and a deposition chamber,
- Fig.3b: shows schematically a lay-out of a cleaning chamber, intermediate chamber and deposition chamber with different air locks at opposite sides of the intermediate chamber,
- Fig.3c: shows schematically a lay-out of a cleaning chamber, intermediate chamber and deposition chamber with gas bearing locks at opposite sides of the intermediate chamber,
- Fig.4a: shows schematically a section through the gas bearing lock between cleaning chamber and deposition chamber,
- Fig.4b: shows schematically a section through opposite gas bearing locks of the intermediate chamber,
- Fig.4c: shows schematically a section through a gas bearing lock provided with a brush in the intermediate chamber,
- Fig.5: shows schematically a lay-out of a cleaning chamber, intermediate chamber and deposition chamber with means to activate the metal strip in the deposition chamber,
- Fig.6: shows schematically a lay-out of a cleaning chamber, intermediate chamber and deposition chamber with gas bearing locks and double coating system, and
- Fig.7: shows schematically a lay-out of a cleaning chamber, intermediate chamber and deposition chamber wherein heating means to heat the space wherein the coating is applied to the metal strip is integrated in the wall of the deposition chamber.

### Detailed description of the drawings

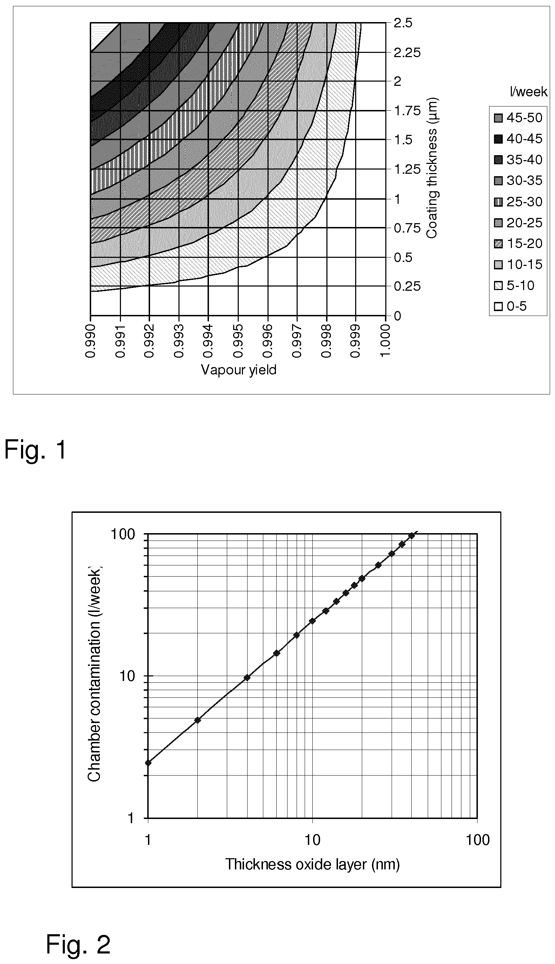

In fig.1 the deposition chamber contamination is shown as function of vapour yield and coating thickness. The coating contamination is proportional to the mass flow of generated vapour, the campaign length and the vapour yield. The contour plot of fig.1 is calculated assuming a strip of 1.0 m wide running at 120 m/min which is coated on both sides with a zinc coating that varies from 0 to 2.5 micron. It is further assumed that the vapour yield lies somewhere between 99 and 100%. The contamination of the deposition chamber is given in litres/week. The contour plot clearly shows that the vapour yield has to be very high to obtain a low contamination value that makes the equipment suitable for continuous or semi-continuous operation.

One advantage of the method according to the invention is the application of the vapour distribution box, with which a vapour yield of ≥ 99% could be realised and which has further been improved with the use of a heat channel. With such a channel the metal coating atoms that initially bounce off the strip are given a second chance to condense on the metal strip. In the description the term "heat channel", is used interchangeably with the terms "hood", "heated hood" and "heat box" and will all mean an envelope forming a space connecting the vapour distribution section and the metal strip which is to be coated. With such an envelope the vapour flow from the vapour distribution section is largely restricted to flow directions directly to the strip surface. Where the metal strip is coated on both sides the "hoods" on either side of the metal strip are preferable connected to form a box, wherein the box is provided with an entry and exit slit for the metal strip.

In fig.2 a diagram is shown of deposition chamber contamination as a function of the thickness of the oxide layer that needs to be etched away for proper metallic coating adhesion. The oxide layer on the metal strip can have a thickness in the range from 1 to 50 nm for a low alloyed steel. In the case of Advanced and Ultra High Strength Steels this can be several tens to several hundreds of nanometres. The chamber contamination in fig.2 shows that with an oxide layer of 10nm the contamination due to plasma cleaning is already in the order of 20-30 litres/week. From this it will be clear that controlling deposition chamber contamination by use of a heat box and higher vacuum pressure has only limited effect if the residue resulting from cleaning of the metal strip is not sufficiently controlled.

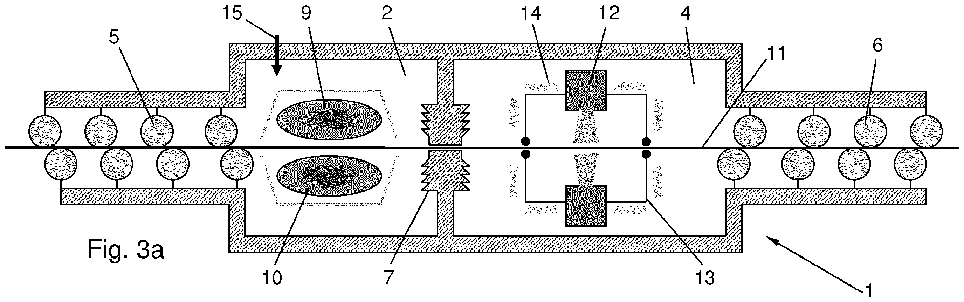

In fig.3a a lay-out of an apparatus 1 is shown schematically, comprising a cleaning chamber 2 and a deposition chamber 4. At the entry of the cleaning chamber 2 and the exit of the deposition chamber 4 air locks 5,6 are provided and between the cleaning chamber 2 and the deposition chamber 4 a gas bearing lock 7 is provided.

In the cleaning chamber 2 plasma cleaning means 9, 10 are provided such as electric arc discharge means or dielectric barrier discharge means. Cleaning by magnetron sputtering is also possible, but the other cleaning techniques are preferably used since these can be operated at much higher vacuum pressures than magnetron sputtering. These techniques can be used at pressures in the range of 0.01 - 100 mbar and at even higher pressures.

The cleaning chamber 2 is provided with a gas inlet 15 to supply gas into the cleaning chamber 2 and with pumping means to remove the gas from the cleaning chamber 2, by means of which a sufficient gas flow through the cleaning chamber 2 is realized to remove residue resulting from the cleaning operation from the cleaning chamber 2. The supply of gas is limited such that a certain pressure is maintained inside cleaning chamber 2. The gas used could be dry air, nitrogen or argon. In the set-up of fig.3a the pumping means to remove gas with the cleaning residue are the pumping means associated with gas bearing lock 7.

In the deposition chamber 4 on both sides of the metal strip 11, for instance a steel strip, a vapour distribution section 12 is provided. The vapour distribution section 12 is provided with nozzles and/or slits as to cover the total width of the metal strip 11. A hood 13 is connected to the vapour distribution section 12 and heating means 14 are provided to heat the hood. If the metal strip 11 is to be coated on both sides the hoods 13 on both sides are preferably connected to each other to form a box, wherein the box is provided with entry and exit slits for the metal strip.

A vapour chamber (not shown in the drawing) wherein a metal is heated to generate a coating vapour is connected to the vapour distribution section 12. The vapour distribution section 12 is operated such that the vapour leaves the vapour distribution section 12 through the nozzles at sonic speed. The hood or heat box is heated to reduce the deposition of the vapour on the heat box. To assure that no contamination is occurring the hood or heat box is heated to a temperature that is equal to or larger than the saturation vapour temperature of the deposited material that corresponds to the pressure of the vapour in the head box or hood. For a Zn-coating the hood or heat box is heated in the temperature interval between 330 and 580°C, this is roughly the Zn temperature range that coincides with a vapour pressure between 0.01 and 10 mbar. The exact temperature of the heat box will also be determined by the maximum allowable strip temperature.

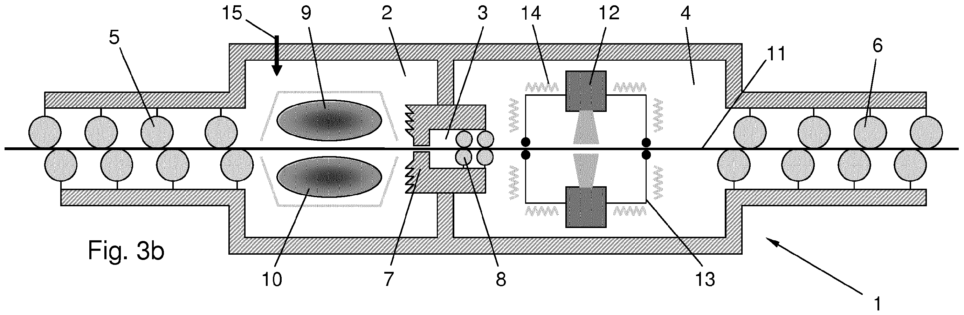

In fig.3b a lay-out of an apparatus 1 is shown schematically, comprising a cleaning chamber 2, an intermediate chamber 3 and a deposition chamber 4. The entry and exit of the intermediate chamber 3 are provided with respectively a gas bearing lock 7 and an air lock 8. By providing an intermediate chamber 3 the removal of residue coming from the cleaning operation can be improved therewith limiting the chance that any residue will enter the deposition chamber 4. Since most if not all of the residue is removed before the strip arrives at the exit of the intermediate chamber 3 a conventional air lock 8 may be used at the exit.

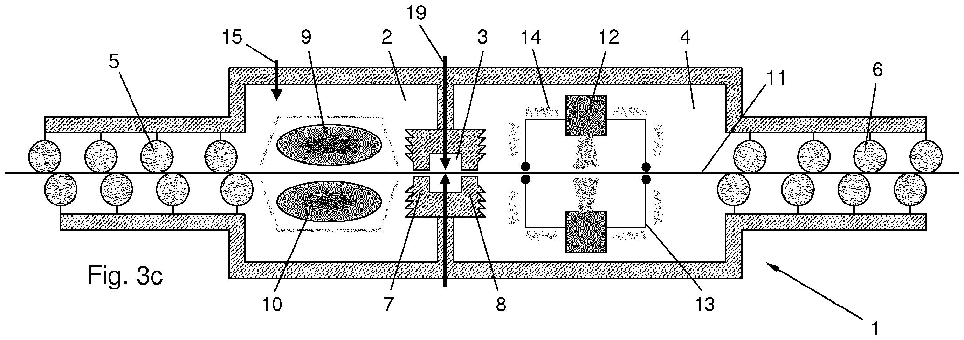

With a conventional air lock the strip 11 has to pass one or more sections with rolls and if there is still residue on the strip or adhering to the strip, the residue will be rolled into the strip which may give rise to certain surface defects in the final product. With the set-up according to fig.3c wherein gas bearing locks 7,8 are provided at the entry and exit of the intermediate chamber 2 this can be avoided.

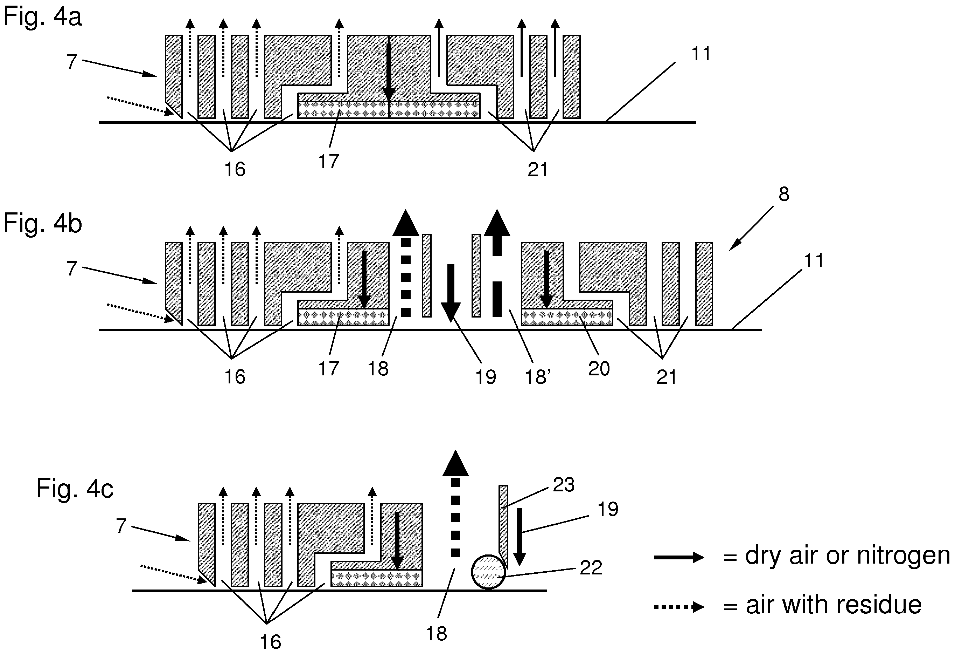

Fig.4a shows a section through gas bearing lock 7 between cleaning chamber 2 and deposition chamber 4. In the drawing only the upper half of the gas bearing lock is shown for the sake of simplicity. Gas bearing lock 7 is provided with number of opposite pairs of grooves 16,21 at both sides of a central gas bearing part 17. Through grooves 16 gas from the cleaning chamber 2 is removed to maintain a certain pressure inside the cleaning chamber and at the same time part of the gas coming through gas bearing part 17 is removed. The grooves 21 at the other side of gas bearing part 17 are also used to remove part of the gas coming through gas bearing part 17 and to maintain a certain vacuum pressure in the deposition chamber 4.

In fig.4b a section through gas bearing lock 7,8 at the entry and exit of the intermediate chamber 3 is shown. Gas bearing lock 7 has a number of opposite pairs of grooves 16 through which gas from the cleaning chamber 2 is removed as well as part of the gas coming through gas bearing part 17. The gas removal through grooves 16 at least part of the residue from the cleaning operation is removed while maintaining a certain pressure inside the cleaning chamber. Gas bearing lock 8 at the exit of the intermediate chamber 3 is of a similar design with opposite gas bearing parts 20 and a number of opposite grooves 21. These grooves 21 are to remove part of the gas coming through gas bearing part 20 and to regulate the pressure in the deposition chamber 4. After passing the final groove 21 the metal strip enters the deposition chamber 4.

Inside the intermediate chamber a pressurised gas supply 19 is provided which is used to remove any residue still on the surface of strip 11. The gas supply may comprise a long slit extending over the width of the strip or a number of nozzles. This manner to remove residue from the strip brings a lot of gas into the intermediate chamber and in order to remove that gas outlet channels 18, 18' are provided at both sides of the pressurised gas supply 19. As far as necessary pumping means may be provided to improve the removal of used supply of pressurised gas. Together with the used gas the residue that is blown of the strip is removed. Through these outlet channels 18,18' also part of the gas coming through the gas bearing parts 17,20 is removed. The amount of residue removed through outlet channel 18 may be larger than the amount that is removed through outlet channel 18' because of the location with respect to the cleaning chamber 2.

The grooves 16, 21, outlet channels 18,18' and gas bearing parts 17,20 continue across the width of the metal strip 11.

The gas supplied through the pressurised gas supply 19 can also be used to cool the strip. Cooling of the strip will be necessary if the temperature of the strip as a result of the cleaning operation has risen above a value that is still acceptable to apply a coating on the strip or where the temperature has risen such that the properties of the strip are altered.

Fig.4c shows the upper part of the gas bearing lock 7 of fig.4b in an embodiment wherein a brush is provided at the location of the pairs of opposite outlet channels 18 following the opposite gas permeable surfaces 17. With the brush 22 any residue still present on or adhering to the surface of metal strip 11 can be removed. The side 23 of groove 18 is used as a scraper to remove residue from brush 22 to keep the brush clean.

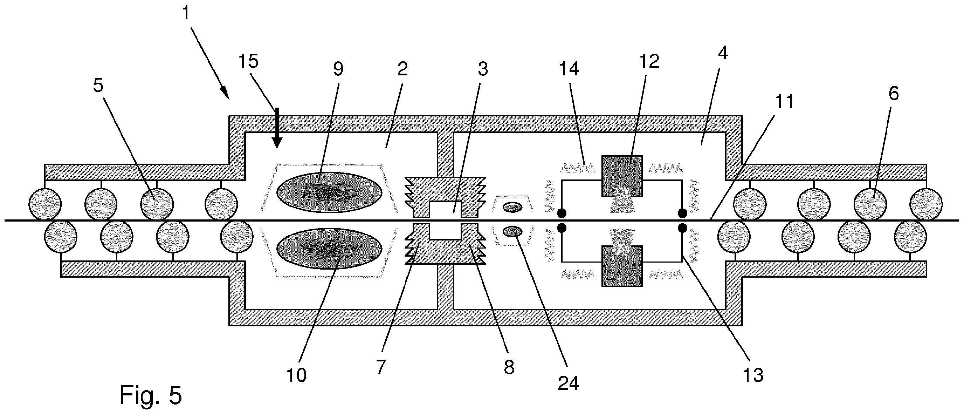

Fig.5 shows another embodiment wherein in the deposition chamber 4 activating means 24 are provided to activate the surface of the metal strip. This is necessary for some metallic coatings such as Zn-Mg coatings to get sufficient adherence of the coating to the metal strip. For activation of the strip magnetron sputtering, glow discharge or dielectric barrier discharge can be used. Electric arc discharge could also be used but the energy level provided is far more than necessary for the purpose.

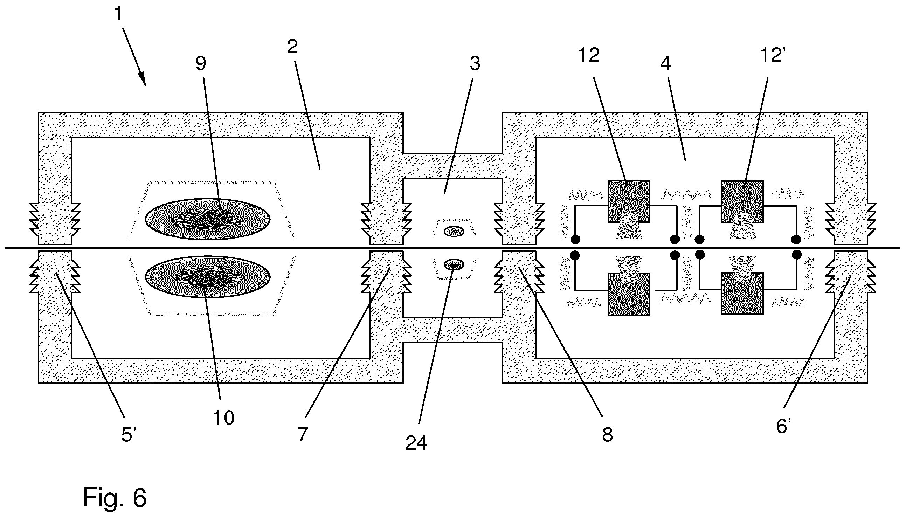

In fig.6 a set-up is shown wherein all entry and exit sections are provided with gas bearing locks 5', 7, 8, 6'. Further two vapour distribution sections 12, 12' are provided which allow to apply coating layers over each other, for instance a Zn coating layer followed by a Zn-Mg coating layer. In the intermediate chamber 3 activating means 24 are provided, which in this set-up are near enough to the first vapour distribution section 12.

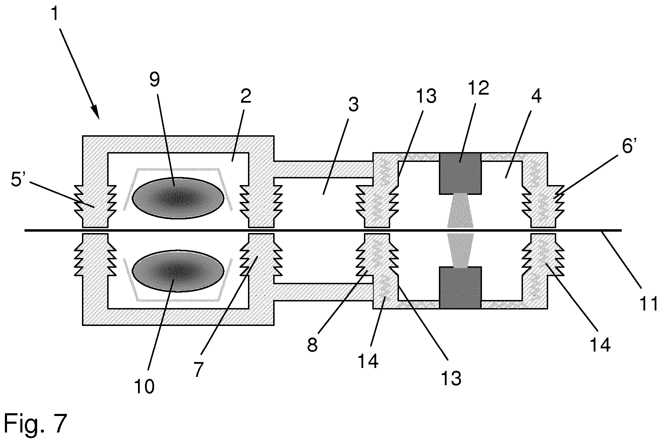

Fig.7 shows schematically a set-up wherein the walls of the deposition chamber 4 form the hood or heat box 13 with the heating means 14 integrated in the walls of the deposition chamber 4. This integrated set-up allows to form a compact deposition chamber 4 / heat box 13. With such combined deposition chamber 4 / heat box 13 the activating means 24, if necessary, are provided in the intermediate chamber 3 which will be close enough to the vapour distribution box 12.

Instead of providing that the complete deposition chamber is formed as a heat box, it is also possible to provide that only part of the deposition chamber facing one side of the metal strip is formed as a heated hood. This would be a suitable embodiment for metal strip that is to be coated on one side only.

## Claims

1. A method for cleaning and coating a metal strip comprising the steps of:
- cleaning the metal strip (11) prior to applying a coating,
- generating a coating vapour by heating a material in a vapour chamber,
- applying the coating vapour in a deposition chamber (4) via a vapour distribution section (12, 12') connected to the vapour chamber on the metal strip (11), and
- wherein the coating is applied in a heated enclosure,
- wherein the metal strip (11) is cleaned in a cleaning chamber (2) connected to the deposition chamber (4) and wherein the pressure in the cleaning chamber (2) is kept in the range of 0.01 - 100 mbar and the pressure in the deposition chamber (4) in the range of 0.01 - 10 mbar
- wherein a gas stream is maintained through the cleaning chamber to remove residues resulting from the cleaning of the metal strip (11) before the metal strip (11) enters the deposition chamber (4),
- wherein the gas stream is maintained by supplying gas (15) into the cleaning chamber (2) while removing the supplied gas with vacuum pump means and by using a gas bearing lock (7) between the cleaning chamber (2) and the deposition chamber (4).

2. A method according to claim 1, wherein the metal strip (11) is cleaned by using a plasma cleaning technique.

3. A method according to one or more of claims 1 - 2, wherein an intermediate chamber (3) is provided between the cleaning chamber (2) and the deposition chamber (4) with gas bearing locks (7,8) connecting the intermediate chamber (3) to the cleaning chamber (2) and the deposition chamber (4).

4. A method according to one or more of claims 1 - 3, wherein the metal strip (11) is mechanically cleaned before entering the deposition chamber (4).

5. A method according to one or more of claims 1 - 4, wherein the metal strip (11) is subjected to a stream of pressurised gas (19) inside the intermediate chamber (3).

6. A method according to one or more of claims 1 - 5, wherein the strip (11) is activated before applying the coating.

7. Apparatus (1) for cleaning and coating a metal strip (11) provided with:
- a deposition chamber (4),
- air locks (5,5',6,6') at the entry and exit sections for the metal strip to enter and exit the apparatus (1),
- a vapour chamber to heat a metal and generate a coating vapour,
- a vapour distribution section (12) with one or more orifices to direct the coating vapour to the metal strip (11),
- a hood (13) at least partially enclosing a space which connects to the distribution section (12) with an open side directed at the metal strip (11) which is to be coated,
- heating means (14) to heat the hood (13), and
- connecting means to connect the vapour chamber to the distribution section (12) in the deposition chamber (4),
- a cleaning chamber (4) provided with a plasma cleaning device (9,10) to clean the metal strip wherein the cleaning chamber (2) is connected to the deposition chamber (4) wherein the coating vapour is applied to the metal strip (11),
- a gas inlet (15) to supply gas into the cleaning chamber (2), and
- vacuum pump means (16) to remove the supplied gas from the cleaning chamber (2).

8. Apparatus according claim 7, wherein the cleaning chamber (2) is provided with means (15) to provide a gas stream through the cleaning chamber (2) and maintaining a vacuum pressure in the range of 0.01 - 100 mbar.

9. Apparatus according to claim 7 or 8, wherein the connection between cleaning chamber (2) and deposition chamber (4) includes an air lock (7,8).

10. Apparatus according to one or more of the preceding claims, wherein the connection between cleaning chamber (2) and deposition chamber (4) includes an intermediate chamber (3) provided with air locks (7,8) on opposite sides.

11. Apparatus according to claim 10, wherein at least one of the air locks (7,8) is a gas bearing lock (7,8) with at least one gas permeable bearing surface (17) with gas supply means and one or more grooves (16) connected to gas pumping means.

12. Apparatus according to claim 11, wherein at least the gas bearing lock (7) at the side of the cleaning chamber (2) is provided with one or more grooves (16) preceding a gas permeable surface (17).

13. Apparatus according to claim 11 or 12, wherein the grooves (16) and gas permeable bearing surfaces (17) are provided in opposite pairs of grooves (16) and bearing surfaces (17,20).

14. Apparatus according to one or more of claims 10 - 12, wherein a pressurised gas supply (19) is provided and means inside the intermediate chamber (3) to guide a stream of pressurised gas at the surface of the metal strip (11).

15. Apparatus (1) according to one or more of the preceding claims, wherein a plasma activation device (24) is provided in the intermediate chamber (3) or deposition chamber (4).

## Patentansprüche

1. Verfahren zum Reinigen und Beschichten eines Metallstreifens, umfassend die folgenden Schritte:
- Reinigen des Metallstreifens (11) vor dem Aufbringen einer Beschichtung,
- Erzeugen eines Beschichtungsdampfes durch Erhitzen eines Materials in einer Dampfkammer,
- Aufbringen des Beschichtungsdampfes in einer Abscheidungskammer (4) über einen Dampfverteilungsabschnitt (12,12'), der mit der Dampfkammer verbunden ist, auf den Metallstreifen (11), und
- wobei die Beschichtung in einem beheizten Gehäuse aufgebracht wird,
- wobei der Metallstreifen (11) in einer mit der Abscheidungskammer (4) verbundenen Reinigungskammer (2) gereinigt wird und wobei der Druck in der Reinigungskammer (2) im Bereich von 0,01 ― 100 mbar und der Druck in der Abscheidungskammer (4) im Bereich von 0,01 ― 10 mbar gehalten wird,
- wobei ein Gasstrom durch die Reinigungskammer aufrechterhalten wird, um Rückstände zu entfernen, die aus der Reinigung des Metallstreifens (11) resultieren, bevor der Metallstreifen (11) in die Abscheidungskammer (4) eintritt,
- wobei der Gasstrom aufrechterhalten wird, indem Gas (15) der Reinigungskammer (2) zugeführt wird, während das zugeführte Gas mit Vakuumpumpmitteln entfernt wird, und indem eine Gaslagersperre (7) zwischen der Reinigungskammer (2) und der Abscheidungskammer (4) verwendet wird.

2. Verfahren nach Anspruch 1, wobei der Metallstreifen (11) unter Verwendung einer Plasmareinigungstechnik gereinigt wird.

3. Verfahren nach einem oder mehreren der Ansprüche 1―2, wobei eine Zwischenkammer (3) zwischen der Reinigungskammer (2) und der Abscheidungskammer (4) vorgesehen ist, wobei Gaslagersperren (7, 8) die Zwischenkammer (3) mit der Reinigungskammer (2) und der Abscheidungskammer (4) verbinden.

4. Verfahren nach einem oder mehreren der Ansprüche 1―3, wobei der Metallstreifen (11) vor dem Eintritt in die Abscheidungskammer (4) mechanisch gereinigt wird.

5. Verfahren nach einem oder mehreren der Ansprüche 1―4, wobei der Metallstreifen (11) einem Druckgasstrom (19) innerhalb der Zwischenkammer (3) ausgesetzt ist.

6. Verfahren nach einem oder mehreren der Ansprüche 1―5, wobei der Streifen (11) vor dem Aufbringen der Beschichtung aktiviert wird.

7. Vorrichtung (1) zum Reinigen und Beschichten eines Metallstreifens (11), versehen mit:
- einer Abscheidungskammer (4),
- Luftschleusen (5,5',6,6') an den Eingangs- und Ausgangsabschnitten, damit der Metallstreifen in die Vorrichtung (1) eintreten und aus dieser austreten kann,
- einer Dampfkammer zum Erwärmen eines Metalls und zum Erzeugen eines Beschichtungsdampfes,
- einem Dampfverteilungsabschnitt (12) mit einer oder mehreren Öffnungen, um den Beschichtungsdampf auf den Metallstreifen (11) zu richten,
- einer Haube (13), die zumindest teilweise einen Raum umschließt, der mit dem Verteilungsabschnitt (12) verbunden ist, wobei eine offene Seite auf den zu beschichtenden Metallstreifen (11) gerichtet ist;
- Heizmitteln (14) zum Erwärmen der Haube (13) und
- Verbindungsmitteln zum Verbinden der Dampfkammer mit dem Verteilungsabschnitt (12) in der Abscheidungskammer (4),
- einer Reinigungskammer (4), die mit einer Plasmareinigungseinrichtung (9, 10) versehen ist, um den Metallstreifen zu reinigen, wobei die Reinigungskammer (2) mit der Abscheidungskammer (4) verbunden ist, wobei der Beschichtungsdampf auf den Metallstreifen (11) aufgebracht wird,
- einem Gaseinlass (15) zum Zuführen von Gas in die Reinigungskammer (2) und
- Vakuumpumpmitteln (16) zum Entfernen des zugeführten Gases aus der Reinigungskammer (2).

8. Vorrichtung nach Anspruch 7, wobei die Reinigungskammer (2) mit Mitteln (15) versehen ist, um einen Gasstrom durch die Reinigungskammer (2) bereitzustellen und einen Vakuumdruck im Bereich von 0,01―100 mbar aufrechtzuerhalten.

9. Vorrichtung nach Anspruch 7 oder 8, wobei die Verbindung zwischen der Reinigungskammer (2) und der Abscheidungskammer (4) eine Luftschleuse (7,8) einschließt.

10. Vorrichtung nach einem oder mehreren der vorhergehenden Ansprüche, wobei die Verbindung zwischen der Reinigungskammer (2) und der Abscheidungskammer (4) eine Zwischenkammer (3) einschließt, die auf gegenüberliegenden Seiten mit Luftschleusen (7,8) versehen ist.

11. Vorrichtung nach Anspruch 10, wobei mindestens eine der Luftschleusen (7,8) eine Gaslagersperre (7,8) mit mindestens einer gasdurchlässigen Lagerfläche (17) mit Gaszufuhrmitteln und einer oder mehreren Nuten (16) ist, die mit Gaspumpmitteln verbunden sind.

12. Vorrichtung nach Anspruch 11, wobei zumindest die Gaslagersperre (7) an der Seite der Reinigungskammer (2) mit einer oder mehreren Nuten (16) versehen ist, die einer gasdurchlässigen Oberfläche (17) vorausgehen.

13. Vorrichtung nach Anspruch 11 oder 12, wobei die Nuten (16) und gasdurchlässigen Lagerflächen (17) in gegenüberliegenden Paaren von Nuten (16) und Lagerflächen (17,20) vorgesehen sind.

14. Vorrichtung nach einem oder mehreren der Ansprüche 10―12, wobei eine Druckgaszufuhr (19) vorgesehen ist und Mittel innerhalb der Zwischenkammer (3) vorhanden sind, um einen Druckgasstrom an der Oberfläche des Metallstreifens (11) zu führen.

15. Vorrichtung (1) nach einem oder mehreren der vorhergehenden Ansprüche, wobei eine Plasmaaktivierungseinrichtung (24) in der Zwischenkammer (3) oder Abscheidungskammer (4) vorgesehen ist.

## Revendications

1. Procédé permettant le nettoyage et le revêtement d'une bande de métal comprenant les étapes de :
- nettoyage de la bande de métal (11) avant l'application d'un revêtement,
- génération d'une vapeur de revêtement en chauffant un matériau dans une chambre de vapeur,
- application de la vapeur de revêtement dans une chambre de dépôt (4) par l'intermédiaire d'une section de distribution de vapeur (12, 12') raccordée à la chambre de vapeur sur la bande de métal (11), et
- ledit revêtement étant appliqué dans une enceinte chauffée,
- ladite bande de métal (11) étant nettoyée dans une chambre de nettoyage (2) raccordée à la chambre de dépôt (4) et ladite pression dans la chambre de nettoyage (2) étant maintenue dans la plage allant de 0,01 à 100 mbar et ladite pression dans la chambre de dépôt (4) étant maintenue dans la plage allant de 0,01 à 10 mbar
- un flux de gaz étant maintenu à travers la chambre de nettoyage pour éliminer les résidus résultant du nettoyage de la bande de métal (11) avant que la bande de métal (11) n'entre dans la chambre de dépôt (4),
- ledit flux de gaz étant maintenu en fournissant du gaz (15) dans la chambre de nettoyage (2) tout en éliminant le gaz fourni avec un moyen de pompe à vide et à l'aide d'un sas à palier à gaz (7) entre la chambre de nettoyage (2) et la chambre de dépôt (4).

2. Procédé selon la revendication 1, ladite bande de métal (11) étant nettoyée à l'aide d'une technique de nettoyage au plasma.

3. Procédé selon une ou plusieurs des revendications 1 à 2, une chambre intermédiaire (3) étant disposée entre la chambre de nettoyage (2) et la chambre de dépôt (4) avec des sas à palier à gaz (7, 8) reliant la chambre intermédiaire (3) à la chambre de nettoyage (2) et à la chambre de dépôt (4).

4. Procédé selon une ou plusieurs des revendications 1 à 3, ladite bande de métal (11) étant nettoyée mécaniquement avant d'entrer dans la chambre de dépôt (4).

5. Procédé selon une ou plusieurs des revendications 1 à 4, ladite bande de métal (11) étant soumise à un flux de gaz sous pression (19) à l'intérieur de la chambre intermédiaire (3).

6. Procédé selon une ou plusieurs des revendications 1 à 5, ladite bande (11) étant activée avant l'application du revêtement.

7. Appareil (1) destiné à nettoyer et à revêtir une bande de métal (11), doté de :
- une chambre de dépôt (4),
- des sas (5,5', 6,6,') au niveau des sections d'entrée et de sortie pour que la bande de métal entre et sorte de l'appareil (1),
- une chambre de vapeur pour chauffer un métal et générer une vapeur de revêtement,
- une section de distribution de vapeur (12) avec un ou plusieurs orifices pour diriger la vapeur de revêtement vers la bande de métal (11),
- une hotte (13) renfermant au moins partiellement un espace qui raccorde la section de distribution (12) à un côté ouvert dirigé vers la bande de métal (11) à revêtir,
- un moyen de chauffage (14) pour chauffer la hotte (13), et
- un moyen de raccordement pour raccorder la chambre de vapeur à la section de distribution (12) dans la chambre de dépôt (4),
- une chambre de nettoyage (4) dotée d'un dispositif de nettoyage au plasma (9, 10) pour nettoyer la bande de métal, ladite chambre de nettoyage (2) étant raccordée à la chambre de dépôt (4), ladite vapeur de revêtement étant appliquée à la bande de métal (11),
- une entrée de gaz (15) pour distribuer du gaz dans la chambre de nettoyage (2), et
- un moyen de pompe à vide (16) pour éliminer le gaz distribué de la chambre de nettoyage (2).

8. Appareil selon la revendication 7, ladite chambre de nettoyage (2) étant dotée de moyens (15) pour fournir un flux de gaz à travers la chambre de nettoyage (2) et maintenir une pression de vide comprise dans la plage de 0,01 à 100 mbar.

9. Appareil selon la revendication 7 ou 8, ledit raccordement entre la chambre de nettoyage (2) et la chambre de dépôt (4) comprenant un sas d'air (7, 8).

10. Appareil selon une ou plusieurs des revendications précédentes, ledit raccordement entre la chambre de nettoyage (2) et la chambre de dépôt (4) comprenant une chambre intermédiaire (3) dotée de sas d'air (7, 8) sur les côtés opposés.

11. Appareil selon la revendication 10, au moins l'un des sas d'air (7, 8) étant un sas à palier à gaz (7, 8) avec au moins une surface de palier perméable aux gaz (17) avec un moyen de distribution de gaz et une ou plusieurs rainures (16) raccordées au moyen de pompage de gaz.

12. Appareil selon la revendication 11, au moins le sas de palier à gaz (7) sur le côté de la chambre de nettoyage (2) étant doté d'une ou plusieurs rainures (16) précédant une surface perméable aux gaz (17).

13. Appareil selon la revendication 11ou 12, lesdites rainures (16) et lesdites surfaces de palier perméables aux gaz (17) étant disposées dans des paires opposées de rainures (16) et de surfaces de palier (17, 20).

14. Appareil selon une ou plusieurs des revendications 10 à 12, une distribution de gaz sous pression (19) étant fournie et un moyen à l'intérieur de la chambre intermédiaire (3) pour guider un flux de gaz sous pression au niveau de la surface de la bande de métal (11).

15. Appareil (1) selon une ou plusieurs des revendications précédentes, un dispositif d'activation par plasma (24) étant disposé dans la chambre intermédiaire (3) ou la chambre de dépôt (4).
